# EUROPÄISCHE PATENTSCHRIFT

(11) **EP 4 405 693 B1**
(45) Veröffentlichungstag und Bekanntmachung des Hinweises auf die Patenterteilung: **31.12.2025**
(21) Anmeldenummer: 22786341.2
(22) Anmeldetag: 15.09.2022
(51) Int. Cl.: G01R 31/34

(54) **MESSANORDNUNG**
MEASURING ASSEMBLY
DISPOSITIF DE MESURE

(30) Priorität: 23.09.2021 DE 102021124678
(43) Veröffentlichungstag der Anmeldung: 31.07.2024
(73) Patentinhaber: ebm-papst Mulfingen GmbH & Co. KG, 74673 Mulfingen (DE)
(72) Erfinder: SCHROTH, Sebastian, 74635 Kupferzell (DE); HEINI, Sébastien, 67280 Urmatt (FR)
(74) Vertreter: Rüger Abel Patentanwälte PartGmbB
(86) Internationale Anmeldenummer: PCT/EP2022/075696
(87) Internationale Veröffentlichungsnummer: WO 2023/046572

(56) Entgegenhaltungen:
- EP-A1- 3 681 035
- DE-A1- 102016 106 431
- US-A1- 2011 050 141
- US-A1- 2017 111 000

## Beschreibung

Die Erfindung betrifft eine Messanordnung für eine elektrische Einrichtung, die mittels einer Inverterschaltung gesteuert werden kann. Bei der elektrischen Einrichtung kann es sich beispielsweise um einen Elektromotor handeln, insbesondere einen bürstenlosen Gleichstrommotor (BLDC). Die Anwendung eignet sich grundsätzlich aber auch für andere Arten von elektrischen Maschinen, beispielsweise Synchronmaschinen oder auch für andere technische Gebiete, beispielsweise Leuchten, bei denen die Leuchtensteuerung eine Inverterschaltung aufweist.

Die Messanordnung hat einen oder mehrere Sensoren, die der elektrischen Einrichtung zugeordnet sind, um dort einen zu messenden Parameter zu erfassen, wie etwa die Temperatur, eine Beschleunigung in eine oder mehrere Raumrichtungen, einen die Feuchtigkeit der umgebenden Atmosphäre beschreibenden Feuchtigkeitsparameter, usw.

DE 10 2016 106 431 A1 beschreibt eine Messanordnung, aufweisend mehrere Zweipole mit jeweils einer Kapazität und einer temperaturabhängigen Impedanz, die in einem Elektromotor parallel zu den Motorsträngen geschaltet sind. Der Elektromotor wird über einen Frequenzumrichter gesteuert. Zusätzliche Leitungen zum Anschließen der Zweipole sind daher nicht erforderlich. Die Stromantwort beim Einschalten des Stromes durch einen der Motorstränge wird durch die temperaturabhängige Impedanz des parallel zum Motorstrang geschalteten Zweipols temperaturabhängig beeinflusst und kann ausgewertet werden, um die Temperatur an der Einbaustelle des Zweipols zu ermitteln.

Aus DE 10 2014 005 706 A1 ist ein Verfahren bekannt, bei dem mittels eines Modells und basierend auf einer Anfangstemperatur die jeweils aktuelle Temperatur berechnet wird.

DE 197 43 046 C1 schlägt vor, zur Temperaturerfassung eines Elektromotors den Motorstrom und die Motorspannung zu erfassen und daraus den Wirkanteil der Motorimpedanz zu ermitteln. Basierend auf einem bekannten Zusammenhang zwischen dem Wirkanteil der Motorimpedanz und der Temperatur (z.B. gemessene Referenzwerte) kann dann eine Temperaturbestimmung erfolgen. Ein ähnliches Verfahren ist auch in DE 196 30 027 A1 beschrieben, bei dem ebenfalls eine Wicklung des Elektromotors unmittelbar als Temperatursensor für die Messung der Spannung und des Stroms verwendet wird.

US2011/050141A1 offenbart eine Messanordnung für eine mittels einer Inverterschaltung gesteuerte elektrische Einrichtung.

Ausgehend vom Stand der Technik ist es die Aufgabe der vorliegenden Erfindung, eine Messanordnung mit einem oder mehreren Sensoren zu schaffen, die einerseits einen geringen Installationsaufwand gewährleistet und andererseits eine unabhängige Auswertung jedes vorhandenen Sensors ermöglicht.

Diese Aufgabe wird durch eine Messanordnung mit den Merkmalen des Patentanspruches 1 gelöst.

Die Messanordnung dient dazu, einen Parameter, beispielsweise eine Temperatur, eine Feuchtigkeit einer umgebenden Atmosphäre, eine Beschleunigung in wenigstens einer Raumrichtung oder einen anderen physikalischen Parameter oder eine beliebige Kombination von mehreren der genannten Parameter an oder in einer elektrischen Einrichtung zu erfassen. Die elektrische Einrichtung wird mittels einer Inverterschaltung gesteuert und kann beispielsweise eine elektrische Maschine, insbesondere ein Elektromotor, sein. Bei einem Beispiel handelt es sich bei dem Elektromotor um einen bürstenlosen Gleichstrommotor (BLDC). Die Inverterschaltung ist vorzugsweise dazu eingerichtet, ein umlaufendes Statormagnetfeld zu erzeugen.

Die Inverterschaltung hat wenigstens einen Inverterausgang, der für die Messanordnung verwendet wird. **Ab**hängig von der Anzahl der zu steuernden Phasen der elektrischen Einrichtung kann die Inverterschaltung auch mehrere Inverterausgänge aufweisen, von denen für die Messanordnung insbesondere ein einziger Inverterausgang verwendet wird. Der Inverterausgang ist mit einer Steuerleitung elektrisch verbunden. Abhängig vom Schaltzustand der Inverterschaltung können an der Steuerleitung unterschiedliche Inverterausgangspotentiale anliegen, beispielsweise ein Versorgungsspannungspotential oder ein Massepotential. Beim Umschalten der Inverterschaltung ändert sich somit das Potential am Inverterausgang und damit auch an der Steuerleitung, die somit nicht auf einem festen Bezugspotential liegt.

Die Messanordnung hat eine Messschaltung. Die Messschaltung ist mit einem Anschluss mit der Steuerleitung des verwendeten Inverterausgangs verbunden. Der Messschaltung wird somit das Inverterausgangspotential übermittelt.

Die Messschaltung ist außerdem mittels einer Messleitung mit einer Sensoreinheit verbunden. Die Messleitung und die Steuerleitung sind lediglich mittelbar über die Messschaltung bzw. die Sensoreinheit miteinander verbunden und können somit unterschiedliche Spannungspotentiale aufweisen.

Die Messschaltung ist dazu eingerichtet, ein Ausgangssignal an die Messleitung anzulegen und über die Messleitung an die Sensoreinheit zu übertragen. Das Ausgangssignal ist vorzugsweise ein durch die Messschaltung definierter Ausgangsstrom. Der Ausgangsstrom ist insbesondere nicht konstant, sondern weist sich ändernde Stromwerte auf. Insbesondere ist das Ausgangssignal ein periodisches Signal, beispielsweise ein sinusförmiges Signal. Die Periodendauer bzw. die Frequenz des Ausgangssignals kann bei einigen Ausführungsbeispielen konstant sein und bei anderen Ausführungsbeispielen variieren.

Die Messschaltung ist außerdem dazu eingerichtet, eine elektrische Messgröße an der Messleitung und/oder der Steuerleitung zu erfassen. Bei einem Ausführungsbeispiel wird als Messgröße eine Messspannung zwischen der Messleitung und der Steuerleitung erfasst.

Die Sensoreinheit weist wenigstens einen Sensor auf. Der Sensor ist der elektrischen Einrichtung zugeordnet und zur Anordnung an oder in der elektrischen Einrichtung eingerichtet. Vorzugsweise ist die Sensoreinheit insgesamt zur Anordnung an oder in der elektrischen Einrichtung eingerichtet und kann auf einem gemeinsamen Träger, beispielsweise einer Leiterplatte, angeordnet sein. Jeder Sensor der Sensoreinheit ist in einem elektrischen Pfad zwischen der Messleitung und der Steuerleitung angeordnet und dazu eingerichtet, das über die Messleitung empfangene Ausgangssignal abhängig von einem zu messenden Parameter zu beeinflussen. Beispielsweise kann der Sensor ein elektrischer Widerstand sein, der seinen Widerstandswert abhängig von dem zu messenden Parameter ändert, beispielsweise abhängig von der Temperatur, der Feuchtigkeit, usw. Dadurch kann beispielsweise die gemessene Messspannung abhängig vom aktuellen Widerstandswert variieren. Alternativ dazu kann die Sensoreinheit auch dazu eingerichtet sein, das Ausgangssignal parameterabhängig zu verändern, beispielsweise zu modulieren, um die Messgröße zu erzeugen. Dabei können alle bekannten Modulationsarten eingesetzt werden. Die Messschaltung kann den von dem wenigstens einen Sensor erfassten Parameter durch eine entsprechende Demodulation ermitteln.

Die Messanordnung weist insbesondere nur eine einzige (einpolige) Messleitung zwischen der Messschaltung und der Sensoreinheit auf. Zusätzlich zu den ohnehin vorhandenen Anschlüssen zwischen der Inverterschaltung und der elektrischen Einrichtung wird nur ein weiterer, einpoliger Anschluss für die Messleitung benötigt. Der Installationsaufwand ist daher gering. Zum Anschließen der Sensoreinheit wird außerdem die ohnehin vorhandene Steuerleitung der Inverterschaltung verwendet. Weil der Modulator und der Demodulator auf das Potential der Steuerleitung bezogen sind, hat ein sich änderndes Inverteratausgangspotential keinen unmittelbaren Einfluss auf die Messschaltung. Die Messschaltung kann somit den zu messenden Parameter, trotz des sich ändernden Inverterausgangspotentials, zuverlässig ermitteln.

Die vorstehend beschriebene Messanordnung verwendet lediglich einen einzigen Inverterausgang, der mit der Steuerleitung verbunden ist. Es können aber auch mehrere unabhängig voneinander arbeitende Messanordnungen verwendet werden, in denen beispielsweise mehrere Inverterausgänge mit jeweils einer Messschaltung und jeweils einer Sensoreinheit verbunden werden, wie es vorstehend beschrieben wurde. Es ist außerdem möglich, mehrere Messschaltungen mit mehreren Sensoreinheiten an einen Inverterausgang anzuschließen. Auch ist es möglich, mehrere Sensoreinheiten an eine Messschaltung anzuschließen. Zwei oder mehrere der oben beschriebenen Varianten können in beliebiger Kombination miteinander verwirklicht werden.

Bei einer bevorzugten Ausführungsform weist die Sensoreinheit mindestens zwei Sensoren und eine Kopplungseinrichtung auf. Die Kopplungseinrichtung ist im elektrischen Pfad zwischen den Sensoren und der Messleitung angeordnet. Sie ist dazu eingerichtet, das Ausgangssignal abhängig von einer Charakteristik des Ausgangssignals zu einem oder mehreren definierten Sensoren einer Sensorgruppe weiterzuleiten. Die Weiterleitung des Ausgangssignals an wenigstens einen anderen Sensor wird durch die Kopplungseinrichtung unterbunden. Auf diese Weise kann die Messschaltung durch Anpassung der Charakteristik des Ausgangssignals gezielt einen Sensor oder eine definierte Sensorgruppe auswählen und den Parameter basierend auf der Messung mittels diesem Sensor bzw. dieser Sensorgruppe ermitteln. Beispielsweise können die Sensoren der Sensoreinheit an unterschiedlichen Orten an oder in der elektrischen Einrichtung angeordnet sein, so dass sich durch Auswahl der an unterschiedlichen Orten angeordneten Sensoren der zu messende Parameter ortsabhängig ermitteln lässt. Bei einem Ausführungsbeispiel können somit die Temperatur, die Feuchtigkeit, usw. an unterschiedlichen Stellen der elektrischen Einrichtung bzw. des Elektromotors ermittelt werden.

Bei der durch die Kopplungseinrichtung auswertbaren Charakteristik des Ausgangssignals kann es sich beispielsweise um die Polarität des Ausgangssignals und/oder die Frequenz des Ausgangssignals und/oder den Betrag des Ausgangssignals handeln.

Bei einer bevorzugten Ausführungsform weist die Kopplungseinrichtung ausschließlich passive Bauelemente, also nicht steuerbare und/oder nicht verstärkende Bauelemente.

Bei einem Ausführungsbeispiel hat die Sensoreinheit genau zwei Sensoren, nämlich einen ersten Sensor und einen zweiten Sensor. Die Kopplungseinrichtung kann dabei ein erstes sperrbares Bauelement, beispielsweise eine erste Diode, und ein zweites sperrbares Bauelement, beispielsweise eine zweite Diode aufweisen. Die erste sperrbare Bauelement und der erste Sensor bilden eine erste Reihenschaltung und das zweite sperrbare Bauelement und der zweite Sensor bilden eine zweite Reihenschaltung. Die beiden Reihenschaltungen sind parallel zueinander zwischen die Messleitung und die Steuerleitung geschaltet sind. Werden als sperrbare Bauelemente Dioden verwendet, sind die Dioden der Kopplungseinrichtung elektrisch in entgegengesetzter Durchlassrichtung zueinander geschaltet. Beispielsweise ist die Kathode der ersten Diode mit dem ersten Sensor und die Anode der zweiten Diode mit dem zweiten Sensor elektrisch verbunden. Bei dieser Anordnung kann abhängig von der Polarität des Ausgangssignals entweder ein Strom durch den ersten Sensor oder ein Strom durch den zweiten Sensor fließen.

Wenn anstelle der passiven Dioden, aktiv ansteuerbare und sperrbare Bauelemente verwendet werden, beispielsweise Transistoren oder Thyristoren, kann die Sensoreinheit auch mehr als zwei auswählbare Sensoren oder Sensorgruppen aufweisen.

Wenn die Kopplungseinrichtung Dioden als Mittel zur Auswahl von einem der angeschlossenen Sensoren aufweist ist es vorteilhaft, wenn das Ausgangssignal unterschiedliche Polaritäten aufweisen kann. Beispielsweise kann das Ausgangssignal ein periodisches Ausgangssignal mit wechselnden Polaritäten sein, beispielsweise ein sinusförmiges Ausgangssignal, ein dreieckförmiges Ausgangssignal, ein Rechteckausgangssignal, usw. Bei anderen Ausgestaltungen der Kopplungseinrichtung kann das periodische Ausgangssignal auch stets dieselbe Polarität (positiv oder negativ, jeweils inklusiv oder exklusiv Null) aufweisen.

Bei einem Ausführungsbeispiel der Messanordnung weist die Kopplungseinrichtung eine Frequenzweiche auf. Die Frequenzweiche kann beispielsweise durch einen oder mehrere Filter gebildet sein, beispielsweise wenigstens einen Hochpass und/oder wenigstens einen Tiefpass und/oder wenigstens einen Bandpass. In diesem Fall kann das Ausgangssignal mit unterschiedlichen Frequenzen erzeugt werden, so dass abhängig von der Frequenz des Ausgangssignals ein oder mehrere Sensoren ausgewählt und zur Bestimmung des zu messenden Parameters verwendet werden können.

Bei einer weiteren Ausführungsform der Messanordnung gehören die Messleitung und die Steuerleitung zu einer Busleitung. Die Busleitung kann beispielsweise gemäß einem definierten Standard ausgebildet sein, beispielsweise dem I²C-Standard. Jeder Sensor der Sensoreinheit kann dann mittels einer Filteranordnung der Kopplungseinrichtung ausgewählt bzw. verwendet werden, wobei die Filteranordnung das Ausgangssignal abhängig von dessen Charakteristik zu einem Sensor durchlässt oder blockiert.

Es ist vorteilhaft, wenn die Messschaltung eine Spannungsversorgung nach Art einer Bootstrap-Spannungsversorgung aufweist, die mit der Steuerleitung verbunden ist. Insbesondere weist die Bootstrap-Spannungsversorgung einen Kondensator auf, der zwischen eine Spannungsversorgungsleitung und die Steuerleitung geschaltet ist. Abhängig vom Schaltzustand der Inverterschaltung und somit vom Inverterausgangspotential an der Steuerleitung kann der Kondensator Energie zum Betreiben der Messschaltung puffern.

Vorzugsweise hat die Messschaltung einen Messausgang, an dem ein Messsignal bereitgestellt wird. Das Messsignal basiert auf der von der Messschaltung erfassten Messgröße. Insbesondere ist das Messsignal potentialunabhängig vom Inverterausgangspotential an der Steuerleitung. Das Messsignal ist sozusagen potentialfrei.

Bei einem Ausführungsbeispiel kann der Messausgang galvanisch von der Steuerleitung und/oder der Messleitung und/oder dem Rest der Messschaltung getrennt sein. Die galvanische Trennung erfolgt vorzugsweise über einen Optokoppler.

Der Messausgang kann als unbeschalteter Transistorausgang ausgebildet sein, beispielsweise als sogenannter Open-Collector-Ausgang (OC) oder als Open-Drain-Ausgang (OD).

Im spannungs- bzw. energielosen Zustand der Messschaltung entspricht das am Messausgang anliegende Messsignal einem Zustand, der eine Überschreitung eines Grenzwertes für den zu messenden Parameter anzeigt, beispielsweise das Überschreiten einer Grenztemperatur, wenn der wenigstens eine Sensor zur Temperaturmessung verwendet wird. Dadurch kann sichergestellt werden, dass bei einem Defekt, beispielsweise bei einem Ausfall der Spannungsversorgung der Messschaltung oder bei einem Defekt in der Ansteuerung des Messausgangs kein sicherheitskritischer Zustand der überwachten elektrischen Einrichtung zugelassen wird.

Bei jeder der oben beschriebenen Ausführungsformen ist es vorteilhaft, wenn die Messschaltung zusammen mit dem Inverter auf einer Platine angeordnet ist. Außerdem ist es vorteilhaft, wenn der Inverter und die Messschaltung, unabhängig davon, ob sie auf einer gemeinsamen Leiterplatte oder eigenen Leiterplatten aufgebaut sind in einem gemeinsamen Gehäuse angeordnet sind. Dies hat den Vorzug, dass die Steuerleitung nicht separat ausgeführt werden muss sondern direkt der Steuerleitung entspricht.

Weiter kann es bei allen vorbeschriebenen Ausführungsformen vorteilhaft sein, wenn das Potential der die Messschaltung speisenden Spannungsquelle auf dasselbe Massepotential wie der Inverter bezogen ist. Daraus ergibt sich ein übersichtlicher Schaltungsaufbau.

Vorteilhafte Ausgestaltungen der Erfindung ergeben sich aus den abhängigen Ansprüchen, der Beschreibung und den Zeichnungen. Nachfolgend werden bevorzugte Ausführungsbeispiele der Erfindung anhand der beigefügten Zeichnungen im Einzelnen erläutert. In den Zeichnungen zeigen:
Figur 1 ein Blockschaltbild einer mittels einer Inverterschaltung gesteuerten elektrischen Einrichtung in Form eines Elektromotors sowie einer dem Elektromotor zugeordneten Messanordnung,
Figur 2 ein Blockschaltbild eines Ausführungsbeispiels der Messanordnung aus Figur 1,
Figuren 3-5 jeweils ein Blockschaltbild eines Ausführungsbeispiels für eine Sensoreinheit der Messanordnung aus Figur 2 und
Figur 6 ein Blockschaltbild eines alternativen Ausführungsbeispiels einer Messanordnung aufweisend eine Busleitung, an die die Sensoreinheit angeschlossen ist,
Figuren 7 und 8 jeweils eine beispielhafte Darstellung eines zeitlichen Verlaufs eines Ausgangssignals, das die Messschaltung an die Sensoreinheit übermittelt.

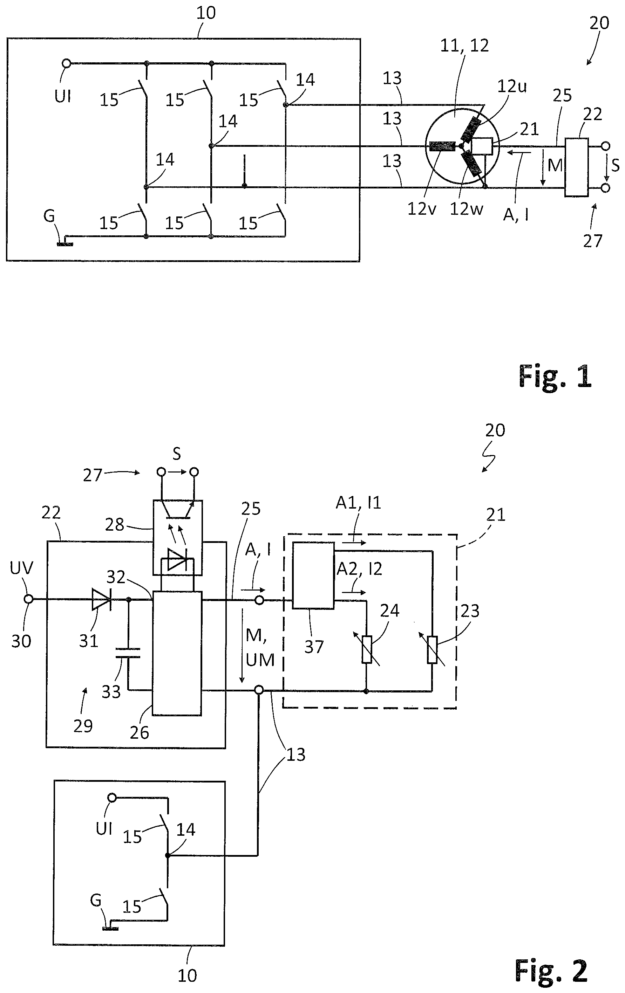

In Figur 1 ist ein Blockschaltbild einer von einer Inverterschaltung 10 gesteuerten elektrischen Einrichtung 11 veranschaulicht, wobei die elektrische Einrichtung 11 bei dem in Figur 1 dargestellten Beispiel ein Elektromotor 12, insbesondere ein bürstenloser Gleichstrommotor ist. Der Elektromotor 12 hat beispielsgemäß drei Motorphasen 12u, 12v, 12w, wobei jede Motorphase 12u, 12v, 12w mittels einer separaten Steuerleitung 13 an jeweils einen zugeordneten Inverterausgang 14 der Inverterschaltung 10 angeschlossen ist. Abhängig von der Anzahl der zu steuernden Motorphasen weist die Inverterschaltung 10 eine entsprechende Anzahl an individuell steuerbaren Inverterausgängen 14 auf.

Die Inverterschaltung 10 hat mehrere steuerbare Inverterschalter 15. Beim Ausführungsbeispiel ist jeder Inverterausgang 14 zwischen zwei in Reihe geschalteten Inverterschaltern 15 angeordnet. Abhängig davon, welcher der beiden in Reihe geschalteten Inverterschalter 15 geschlossen ist, kann jeder Inverterausgang 14 entweder mit einer der Inverterschaltung 10 bereitgestellten Inverterspannung UI oder alternativ mit Masse G verbunden werden. Von den in Reihe geschalteten, mit einem gemeinsamen Inverterausgang 14 verbundenen Inverterschaltern 15 ist jeweils nur ein Inverterschalter 15 leitend, während der jeweils andere Inverterschalter 15 sperrt. An jedem Inverterausgang 14 bzw. an jeder Steuerleitung 13 kann somit als Inverterausgangspotential die Inverterspannung UI oder alternativ Massepotential der Masse G anliegen. Das Inverterausgangspotential an der Steuerleitung 13 ist somit nicht konstant, sondern wechselt abhängig vom Schaltzustand der Inverterschaltung 10.

Eine Messanordnung 20 aufweisen eine Sensoreinheit 21 und eine Messschaltung 22 ist mit einer der Steuerleitungen 13 verbunden. Die Messanordnung 20 könnte auch mehrere Gruppen von jeweils einer Sensoreinheit 21 und jeweils einer Messschaltung 22 aufweisen, die jeweils mit einer separaten Steuerleitung 13 verbunden sind. Die Messanordnung 20 ist dazu eingerichtet, mittels der Sensoreinheit 21 einen Parameter an oder in der elektrischen Einrichtung 11 bzw. dem Elektromotor 12 zu messen, beispielsweise eine Temperatur, eine Feuchtigkeit der umgebenden Atmosphäre, eine Beschleunigung in wenigstens eine Raumrichtung, einen Strom, eine Spannung, usw. oder eine beliebige Kombination davon. Hierzu weist die Sensoreinheit 21 wenigstens einen Sensor, vorzugsweise mehrere Sensoren und beim Ausführungsbeispiel einen ersten Sensor 23 und einen zweiten Sensor 24 auf.

Die Sensoren 23, 24 können auf einem gemeinsamen Träger, beispielsweise einer Leiterplatte, angeordnet sein. Der Träger und/oder die Sensoren 23, 24 sind vorzugsweise in wärmeleitender Verbindung mit der Wicklung von zumindest einer der Motorphasen 12u, 12v, 12w, beispielsweise in unmittelbarer Anlage, wie es lediglich stark schematisiert in Figur 1 veranschaulicht ist. Dies ist beim Ausführungsbeispiel deswegen vorteilhaft, weil die Sensoreinheit 21 vorzugsweise dazu eingerichtet ist, wenigstens einen Temperaturwert wenigstens einer Wicklung von wenigstens einer der Motorphasen 12u, 12v, 12w zu erfassen. Die Sensoren 23, 24 können mit unterschiedlichen Wicklungen bzw. unterschiedlichen Motorphasen in wärmeleitender Verbindung stehen. Allgemein gesprochen ist zur Temperaturerfassung der wenigstens eine Sensor 23, 24 an der Stelle in oder an der elektrischen Einrichtung 11 (hier: Elektromotor 12) angeordnet, an der die Temperatur erfasst werden soll.

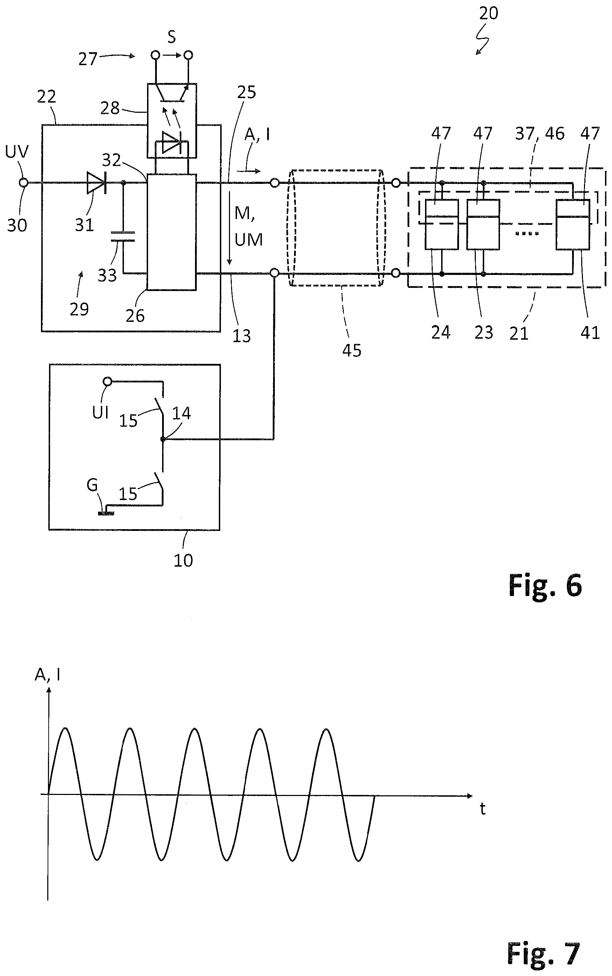

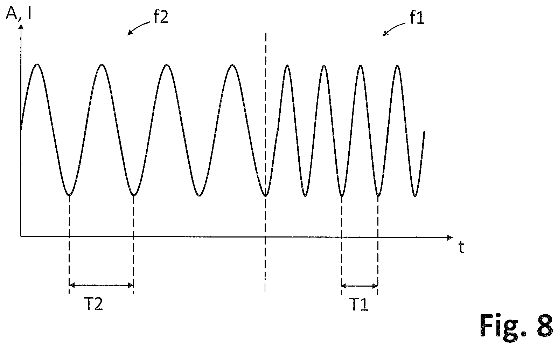

Die Messschaltung 22 ist mittels einer Messleitung 25 mit der Sensoreinheit 21 verbunden und kann über die Messleitung 25 ein Ausgangssignal A an die Sensoreinheit 21 übermitteln. Das Ausgangssignal A kann ein Ausgangsstrom I sein, der durch die Messschaltung 22 definiert wird. Das Ausgangssignal A ist vorzugsweise nicht konstant, sondern hat einen sich zeitlich ändernden Verlauf, vorzugsweise einen periodischen Verlauf, wie es in den Ausführungsbeispielen gemäß der Figuren 7 und 8 dargestellt ist. Das Ausgangssignal A und beispielsgemäß der definierte Ausgangsstrom I kann wenigstens eine Charakteristik bzw. Eigenschaft haben, die durch die Sensoreinheit 21 auswertbar ist bzw. die zu unterschiedlichen Effekten oder Zuständen in der Sensoreinheit 21 führt. Diese Charakteristik kann beispielsweise die Polarität des Ausgangssignals sein, wie es beispielhaft in Figur 7 dargestellt ist. Die Charakteristik kann bei einem anderen Ausführungsbeispiel die Frequenz des Ausgangssignals A sein (Figur 8). Auch ein anderer veränderbarer Parameter, wie etwa ein Betrag bzw. die Amplitude des Ausgangssignals, ein Flankenverlauf (steigend oder fallend), eine Flankensteilheit, usw. können alternativ oder zusätzlich als Charakteristik zur Beeinflussung der Sensoreinheit 21 verwendet werden.

Beim Ausführungsbeispiel hat das Ausgangssignal A bzw. der Ausgangsstrom I einen sich zeitlich ändernden Betrag und kann beispielsweise ein periodisches Signal sein. Als periodisches Signal ist in den Figuren 7 und 8 beispielhaft ein sinusförmiger Verlauf dargestellt. Auch andere Signalverläufe, beispielsweise ein Rechtecksignal, ein Dreiecksignal, ein Sägezahnsignal, usw. können verwendet werden. Die Signalform des Ausgangssignals A kann im Prinzip beliebig gewählt werden.

In Figur 2 ist ein Ausführungsbeispiel der Messanordnung 20 veranschaulicht, wobei lediglich einer der Inverterausgänge 14 der Inverterschaltung 10 dargestellt ist, der für die Messanordnung 20 verwendet wird. Bei dem Ausführungsbeispiel weist die Sensoreinheit 21 mehrere Sensoren und beispielsgemäß einen ersten Sensor 23 und einen zweiten Sensor 24 auf. Die Sensoren 23, 24 sind über eine Kopplungseinrichtung 37 mit der Messleitung 25 verbunden. Die Kopplungseinrichtung 37 ist somit im elektrischen Pfad zwischen der Messleitung 25 und den Sensoren 23, 24 angeordnet. Die Kopplungseinrichtung 37 ist dazu eingerichtet, abhängig von der Charakteristik des Ausgangssignals A und beispielsgemäß des Ausgangsstroms I das Ausgangssignal A bzw. den Ausgangsstrom I als erstes Ausgangssignal A1 bzw. ersten Ausgangsstrom I1 an den ersten Sensor 23 weiterzuleiten oder das Ausgangssignal A bzw. den Ausgangsstrom I als zweites Ausgangssignal A2 bzw. zweiten Ausgangsstrom I2 an den zweiten Sensor 24 weiterzuleiten. Somit kann abhängig von der eingestellten Charakteristik des Ausgangssignals A die Ermittlung des zu erfassenden Parameters entweder anhand des ersten Sensors 23 oder anhand des zweiten Sensors 24 erfolgen. Bevorzugt wird zu jedem Zeitpunkt das Ausgangssignal A mittels der Kopplungseinrichtung 37 lediglich an einen der angeschlossenen Sensoren 23 oder 24 weitergeleitet. Die Kopplungseinrichtung 37 kann sozusagen eine Art Weiche oder einen Schalter bilden, der seinen Zustand basierend auf der Charakteristik des Ausgangssignals A ändert.

Die Messschaltung 22 ist dazu eingerichtet, an der Messleitung 25 und/oder der Steuerleitung 13 eine elektrische Messgröße M zu erfassen, beispielgemäß eine Messspannung UM zwischen der Messleitung 25 und der Steuerleitung 13. Basierend auf der elektrischen Messgröße M erzeugt die Messschaltung 22 ein Messsignal S, das an einem Messausgang 27 der Messschaltung 22 bereitgestellt wird. Der Messausgang 27 ist vorzugsweise als unbeschalteter Transistorausgang ausgeführt, beispielsweise als Open-Collector-Ausgang oder alternativ als Open-Drain-Ausgang, abhängig von der Ausführung des Transistors (Bipolartransistor oder Feldeffekttransistor).

Eine Auswerteeinheit 26 der Messschaltung 22 ist sowohl mit der Messleitung 25, als auch der Steuerleitung 13 verbunden und dient zur Erzeugung des Ausgangssignals A sowie zur Erfassung der elektrischen Messgröße **M.** Sie ist beim Ausführungsbeispiel auch dazu eingerichtet, das Messsignal S an einem Messausgang 27 der Messschaltung 22 bereitzustellen.

Das Messsignal S kann ein analoges Signal oder ein digitales Signal sein. Das Messsignal S kann die elektrische Messgröße M beispielsweise durch einen analogen Wert oder durch eine Modulation, beispielsweise eine Pulsweitenmodulation, angeben.

Der Messausgang 27 ist vorzugsweise galvanisch getrennt von der Auswerteeinheit 26, der Messleitung 25 und der Steuerleitung 13. Zur galvanischen Trennung kann beispielsweise ein Optokoppler 28 verwendet werden. Eine Leuchtdiode des Optokopplers 28 ist mit der Auswerteeinheit 26 der Messschaltung 22 verbunden und wird durch die Auswerteeinheit 26 abhängig von der elektrischen Messgröße M und beispielsgemäß der Messspannung UM angesteuert. D

Die Messschaltung 22 weist außerdem eine interne Spannungsversorgung auf, an die eine externe Versorgungsspannung UV angelegt wird. Die Spannungsversorgung der Messschaltung 22 ist beim Ausführungsbeispiel als Bootstrap-Spannungsversorgung 29 ausgeführt. Die Bootstrap-Spannungsversorgung weist einen Versorgungsanschluss 30 zum Anlegen der Versorgungsspannung UV auf, der über eine Eingangsdiode 31 mit einem Eingang 32 der Auswerteeinheit 26 verbunden ist. Dabei ist die Anode der Eingangsdiode 31 mit dem Versorgungsanschluss 30 und die Kathode der Eingangsdiode 31 mit dem Eingang 32 verbunden.

Zwischen dem Eingang 32 und der Steuerleitung 13 ist beispielsgemäß ein Pufferkondensator 33 der Bootstrap-Spannungsversorgung 29 geschaltet. Der Pufferkondensator 33 kann elektrische Energie zur Versorgung der Auswerteeinheit 26 speichern. Der Pufferkondensator 33 wird geladen, wenn das Inverterausgangspotential an der Steuerleitung 13 dem Massepotential der Masse G entspricht. Entspricht das Inverterausgangspotential an der Steuerleitung 13 der Inverterspannung UI, kann die Auswerteeinheit 26 elektrische Energie aus dem Pufferkondensator 33 zum Betrieb entnehmen. Über die Eingangsdiode 31 wird verhindert, dass ein Entladestrom aus dem Pufferkondensator 33 zum Versorgungsanschluss 30 fließen kann.

Die Sensoren 23, 24 der Sensoreinheit 21 können als parameterabhängige Widerstände ausgebildet sein. Beim Ausführungsbeispiel ändert sich der Widerstandswert der Sensoren 23, 24 abhängig von der Temperatur. Dabei kann der Widerstandswert abhängig von der Temperatur zunehmen oder abnehmen. Somit ändert sich beispielsweise die Messspannung UM abhängig vom Widerstandswert des ersten Sensors 23, wenn durch den ersten Sensor 23 der erste Ausgangsstrom I1 fließt oder abhängig vom Widerstandswert des zweiten Sensors 24, wenn der zweite Ausgangsstrom I2 durch den zweiten Sensor 24 fließt.

Wenn anstelle der Temperatur ein anderer Parameter erfasst werden soll, können auch Sensoren 23, 24 verwendet werden, deren Widerstandswerte sich abhängig von dem entsprechenden zu erfassenden Parameter ändern, beispielsweise abhängig von der Feuchtigkeit in der umgebenden Atmosphäre, usw.

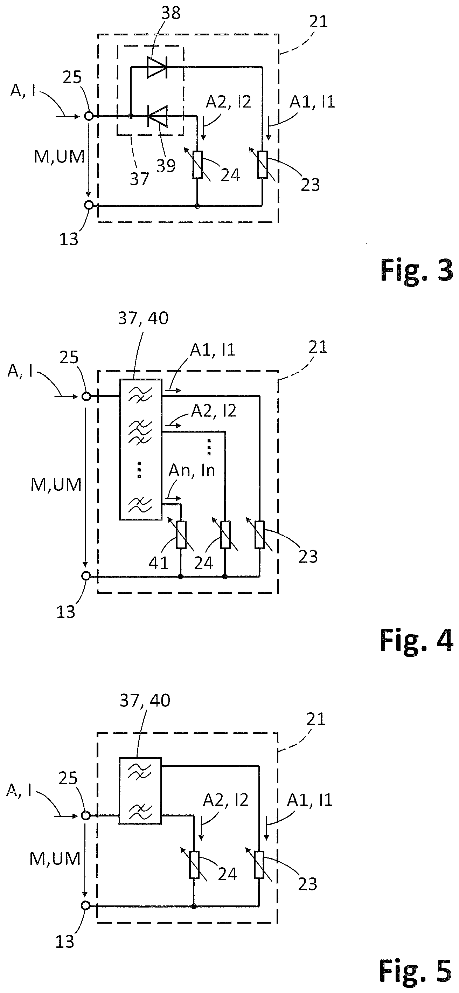

In Figur 3 ist ein Blockschaltbild eines Ausführungsbeispiels der Sensoreinheit 21 veranschaulicht, die insbesondere bei Ausführungsbeispielen zweckmäßig ist, bei denen die Sensoreinheit 21 genau zwei Sensoren 23, 24 aufweist. Bei diesem Ausführungsbeispiel hat die Kopplungseinrichtung 37 eine erste Diode 38, die in Reihe geschaltet ist zum ersten Sensor 23 und eine zweite Diode 39, die in Reihe geschaltet ist zum zweiten Sensor 24. Diese beiden Reihenschaltungen sind parallel zueinander zwischen die Messleitung 25 und die Steuerleitung 13 geschaltet. Die Kathode der ersten Diode 38 ist dabei mit dem ersten Sensor 23 verbunden, während in der anderen Reihenschaltung die Anode der zweiten Diode 39 mit dem zweiten Sensor 24 verbunden ist. Abhängig von der Polarität des Ausgangssignals A ist somit lediglich einer der Dioden 38, 39 leitend, während die andere Diode 39 bzw. 38 sperrt. Bei diesem Ausführungsbeispiel leitet die Kopplungseinrichtung 37 das Ausgangssignal A abhängig von dessen Polarität (beispielsgemäß als Charakteristik verwendet) entweder als erstes Ausgangssignal A1 an den ersten Sensor 23 oder als zweites Ausgangssignal A2 an den zweiten Sensor 24 weiter. Das Ausgangssignal A bzw. der Ausgangsstrom I mit wechselnder Polarität ist beispielhaft in Figur 7 veranschaulicht. Während der positiven Anteile des Ausgangssignals A ist somit der erste Sensor 23 aktiv, während der negativen Anteile des Ausgangssignals A der zweite Sensor 24 aktiv ist. Zu jedem Zeitpunkt beschreibt die Messspannung UM daher entweder die vom ersten Sensor 23 erfasste Temperatur (positive Anteile des Ausgangssignals A) oder die vom zweiten Sensor 24 erfasste Temperatur (negative Anteile des Ausgangssignals A) .

Diese Ausführungsform der Sensoreinheit 21 bzw. der Kopplungseinrichtung 37 ermöglicht somit auf einfache Weise das Auswählen bzw. Verwenden entweder des ersten Sensors 23 oder des zweiten Sensors 24 zur Temperaturerfassung.

Beim Ausführungsbeispiel nach Figur 3 weist die Kopplungseinrichtung 37 ausschließlich passive Bauelemente, nämlich Dioden 38, 39 auf. Es ist bevorzugt, wenn die Kopplungseinrichtung 37 ohne aktive Bauelemente, **d.h.** ohne ansteuerbare und/oder verstärkende Bauelemente realisiert wird, um einen einfachen Aufbau und eine einfache Funktionsweise der Messanordnung 20 zu gewährleisten.

Weitere Ausführungsbeispiele der Sensoreinheit 21 mit mehreren Sensoren sind in den Figuren 4 und 5 beispielhaft veranschaulicht. Auch bei diesen Sensoreinheiten 21 kann die Kopplungseinrichtung 37 ausschließlich mit passiven Bauelementen realisiert werden.

Bei den Ausführungsbeispielen gemäß der Figuren 4 und 5 weist die Kopplungseinrichtung 37 eine Frequenzweiche 40 auf oder ist durch eine Frequenzweiche 40 gebildet. Die Kopplungseinrichtung 37 ist dadurch dazu eingerichtet, abhängig von der Frequenz des Ausgangssignals A als charakteristische Eigenschaft das Ausgangssignal A an einen der Ausgänge der Kopplungseinrichtung 37 weiterzuleiten und somit beispielsgemäß an einen der angeschlossenen Sensoren. Abhängig von der Ausgestaltung der Frequenzweiche 40 können hierbei eine Anzahl n von Sensoren über n-Ausgänge der Kopplungseinrichtung 37 individuell angesteuert werden, wie es schematisch in Figur 4 dargestellt ist. Zusätzlich zu dem ersten Sensor 23 und dem zweiten Sensor 24 können daher wenigstens ein weiterer Sensor 41 verwendet werden. Aufgrund der Frequenzweiche 40 wird das Ausgangssignal A entweder als erstes Ausgangssignal A1 an den ersten Sensor 23, als zweites Ausgangssignal A2 an den zweiten Sensor 24 oder als wenigstens ein weiteres Ausgangssignal An an einen der weiteren Sensoren 41 weitergeleitet. Die Anzahl der auswählbaren und verwendbaren Sensoren 23, 24, 41 hängt von der Feinheit der Abstufung der Frequenzweiche 40 ab.

Die Frequenzweiche 40 kann durch Frequenzfilter realisiert werden, beispielsweise wenigstens einen Hochpass, wenigstens einen Bandpass, wenigstens einen Tiefpass oder eine beliebige Kombination davon.

In Figur 5 ist eine einfache Realisierungsmöglichkeit der Sensoreinheit 21 gemäß Figur 4 dargestellt, wenn lediglich ein erster Sensor 23 und ein zweiter Sensor 24 vorhanden sind. In diesem Fall kann die Frequenzweiche 40 der Kopplungseinrichtung 37 sehr einfach durch einen Hochpass und einen Tiefpass realisiert werden (Figur 5).

In Figur 8 ist schematisch beispielhaft ein zeitlicher Verlauf eines Ausgangssignals A bzw. eines Ausgangsstroms I dargestellt, dass einen periodischen Verlauf hat, der beim bevorzugten Ausführungsbeispiel immer nur eine Polarität aufweist. Dabei kann sich die Frequenz bzw. Periodendauer des Ausgangssignals A ändern und beispielsweise zwischen einer ersten Frequenz f1 und einer zweiten Frequenz f2 umgeschaltet werden. Dieses Ausgangssignal A kann beispielsweise zur Verwendung der Sensoreinheit 21 gemäß Figur 5 eingesetzt werden. Wenn mehr als zwei individuell auswählbare Sensoren (Anzahl n) vorhanden sind (Figur 4), kann das Ausgangssignal A gemäß Figur 8 zwischen einer Anzahl n unterschiedlichen Frequenzen f1, f2, ... fn umgeschaltet werden.

Ein weiteres Ausführungsbeispiel für eine Messanordnung 20 ist schematisch in Figur 6 veranschaulicht. Dort bilden die Messleitung 25 und die Steuerleitung 13 gemeinsam eine Busleitung 45 entsprechend einem definierten Standard, beispielsweise dem I²C-Standard. Die Kopplungseinrichtung 37 ist bei diesem Ausführungsbeispiel durch eine Filteranordnung 46 gebildet, wobei die Filteranordnung 46 jeweils einen Filter 47 aufweist, der in Reihe zu jeweils einem der individuell ansteuerbaren Sensoren 23, 24, 41 angeordnet ist. Auch bei dieser Ausführungsform können im Prinzip beliebig viele Sensoren (Anzahl n) individuell über die Busleitung 45 angesteuert werden.

Die Erfindung betrifft eine Messanordnung zur Messung eines Parameters an einer elektrischen Einrichtung 11, insbesondere einem Elektromotor 12. Die elektrische Einrichtung 11 wird über eine Inverterschaltung 10 gesteuert. Die Messanordnung 20 hat eine Messschaltung 22, die mittels einer Messleitung 25 mit einer Sensoreinheit 21 aufweisend wenigstens einen Sensor 23, 24 elektrisch verbunden ist. Die Messschaltung 22 ist außerdem mit einer Steuerleitung 13 verbunden, die die elektrische Einrichtung 11 mit einem Inverterausgang 14 der Inverterschaltung 10 verbindet. An der Steuerleitung 13 können abhängig vom Schaltzustand des Inverterausgangs 14 bzw. der Inverterschaltung 10 wenigstens zwei unterschiedliche Inverterausgangspotentiale anliegen. Die Messschaltung 22 ist dazu eingerichtet, ein Ausgangssignal A an die Sensoreinheit 21 zu übertragen und eine elektrische Messgröße M an der Messleitung 25 und/oder der Steuerleitung 13 zu erfassen. Die elektrische Messgröße M wird basierend auf dem empfangenen Ausgangssignal A durch die Sensoreinheit 21 abhängig von dem zu erfassenden Parameter, beispielsweise der Temperatur, beeinflusst. Beispielsweise können die Sensoren 23, 24, 41 hierfür einen parameterabhängigen Widerstand aufweisen.

### Bezugszeichenliste:

- 10: Inverterschaltung
- 11: elektrische Einrichtung
- 12: Elektromotor
- 12u: Motorphase des Elektromotors
- 12v: Motorphase des Elektromotors
- 12w: Motorphase des Elektromotors
- 13: Steuerleitung
- 14: Inverterausgang
- 15: Inverterschalter

- 20: Messanordnung
- 21: Sensoreinheit
- 22: Messschaltung
- 23: erster Sensor
- 24: zweiter Sensor
- 25: Messleitung
- 26: Auswerteeinheit
- 27: Messausgang
- 28: Optokoppler
- 29: Bootstrap-Spannungsversorgung
- 30: Versorgungsanschluss
- 31: Eingangsdiode
- 32: Eingang der Auswerteeinheit
- 33: Pufferkondensator

- 37: Kopplungseinrichtung
- 38: erste Diode
- 39: zweite Diode
- 40: Frequenzweiche
- 41: weiterer Sensor
- 45: Busleitung
- 46: Filteranordnung
- 47: Filter

- A: Ausgangssignal
- A1: erstes Ausgangssignal
- A2: zweites Ausgangssignal
- An: weiteres Ausgangssignal
- f1: erste Frequenz des Ausgangssignals
- f2: zweite Frequenz des Ausgangssignals
- G: Masse
- I: Ausgangsstrom
- I1: erster Ausgangsstrom
- I2: zweiter Ausgangsstrom
- M: Messgröße
- S: Messsignal
- t: Zeit
- T1: erste Periodendauer des Ausgangssignals
- T2: zweite Periodendauer des Ausgangssignals
- UI: Inverterspannung
- UM: Messspannung
- UV: Versorgungsspannung

## Patentansprüche

1. Messanordnung (20) für eine mittels eines Inverterschaltung (10) gesteuerte elektrische Einrichtung (11) aufweisend:
- eine mit einem Inverterausgang (14) der Inverterschaltung (10) verbundene Steuerleitung (13), an der ein von der Inverterschaltung (10) vorgegebenes Inverterausgangspotential anliegt,
- eine Messschaltung (22), die mittels einer Messleitung (25) mit einer Sensoreinheit (21) und zusätzlich mit der Steuerleitung (13) verbunden ist, und die dazu eingerichtet ist, ein Ausgangssignal (A) mittels der Messleitung (25) an die Sensoreinheit (21) zu übertragen und die außerdem dazu eingerichtet ist, eine elektrischen Messgröße (M) an der Messleitung (25) und/oder Steuerleitung (13) zu erfassen,
- wobei die Sensoreinheit (21) wenigstens einen Sensor (23, 24, 41) aufweist, der zur Anordnung an oder in der elektrischen Einrichtung (11) eingerichtet ist, wobei jeder Sensor (23, 24, 41) in einem elektrischen Pfad zwischen der Messleitung (25) und der Steuerleitung (13) angeordnet und dazu eingerichtet ist, das Ausgangssignal (A) abhängig von einem zu messenden Parameter zu beeinflussen.

2. Messanordnung nach Anspruch **1,** wobei die Sensoreinheit (21) wenigstens zwei Sensoren (23, 24, 41) und eine Kopplungseinrichtung (37) aufweist, wobei die Kopplungseinrichtung (37) im elektrischen Pfad zwischen den Sensoren (23, 24, 41) und der Messleitung (25) angeordnet und dazu eingerichtet ist, abhängig von einer Eigenschaft des Ausgangssignals (A) eine Weiterleitung des Ausgangssignals (A) zu einem von den wenigstens zwei Sensoren (23, 24, 41) zuzulassen.

3. Messanordnung nach Anspruch **2,** wobei die Kopplungseinrichtung (37) ausschließlich passive Bauelemente aufweist.

4. Messanordnung nach Anspruch 2 oder **3,** wobei die Sensoreinheit (21) einen ersten Sensor (23) und einen zweiten Sensor (24) aufweist, wobei die Kopplungseinrichtung (37) ein erstes sperrbares Bauelement und ein zweites sperrbares Bauelement aufweist, wobei eine erste Reihenschaltung aufweisend das erste sperrbare Bauelement und den ersten Sensor (23) und eine zweite Reihenschaltung aufweisend das zweite sperrbare Bauelement und den zweiten Sensor (24) parallel zueinander zwischen die Messleitung (25) und die Steuerleitung (13) geschaltet sind.

5. Messanordnung nach Anspruch **4,** wobei das erste sperrbare Bauelement eine erste Diode (38) und das zweite sperrbare Bauelement eine zweite Diode (39) ist, die antiparallel zueinander geschaltet sind und die Messschaltung (22) dazu eingerichtet ist, das Ausgangssignal (A) derart zu erzeugen, dass es unterschiedliche Polaritäten aufweist.

6. Messanordnung nach Anspruch 2 oder **3,** wobei die Kopplungseinrichtung (37) eine Frequenzweiche (40) aufweist.

7. Messanordnung nach Anspruch 6, wobei die Messschaltung (22) dazu eingerichtet ist, das Ausgangssignal (A) derart zu erzeugen, dass es unterschiedliche Frequenzen (f1, f2) aufweist.

8. Messanordnung nach Anspruch 2 oder 3, wobei die Kopplungseinrichtung (37) eine Filteranordnung (46) aufweist.

9. Messanordnung nach Anspruch 8, wobei die Messleitung (25) und die Steuerleitung (13) zu einer Busleitung (45) gehören, an die die wenigstens zwei Sensoren (23, 24, 41) mittels der Filteranordnung (46) angeschlossen sind.

10. Messanordnung nach einem der vorhergehenden Ansprüche, wobei die Messschaltung (22) eine Bootstrap-Spannungsversorgung (29) aufweist, die mit der Steuerleitung (13) verbunden ist.

11. Messanordnung nach einem der vorhergehenden Ansprüche, wobei die Messschaltung einen Messausgang (27) aufweist, und wobei die Messschaltung (22) dazu eingerichtet ist, basierend auf der Messgröße (M) ein Messsignal (S) zu erzeugen und am Messausgang (27) bereitzustellen.

12. Messanordnung nach Anspruch 11, wobei das Messsignal (S) potentialunabhängig vom Inverterausgangspotential der Steuerleitung (13) ist.

13. Messanordnung nach Anspruch 11 oder 12, wobei der Messausgang (27) galvanisch von der Steuerleitung (13) und/oder der Messleitung (25) getrennt ist.

14. Messanordnung nach einem der Ansprüche 11 bis 13, wobei der Messausgang (27) als ein unbeschalteter Transistorausgang ausgebildet ist.

15. Messanordnung nach einem der vorhergehenden Ansprüche, wobei der wenigstens eine Sensor (23, 24, 41) einen Widerstand aufweist, der dazu eingerichtet ist, seinen Widerstandswert abhängig vom zu messenden Parameter zu ändern.

## Claims

1. Measuring assembly (20) for an electrical device (11) that is controlled by means of an inverter circuit (10), comprising:
- a control line (13) connected with an inverter output (14) of inverter circuit (10), at which an inverter output potential applies, which is predefined by the inverter circuit (10),
- a measuring circuit (22) that is connected with a sensor unit (21) via a measuring line (25) and in addition with the control line (13) and that is configured to transmit an output signal (A) via the measuring line (25) to the sensor unit (21) and that is in addition configured to detect an electrical measured parameter (M) at the measuring line (25) and/or the control line (13),
- wherein the sensor unit (21) comprises at least one sensor (23, 24, 41), which is configured for arrangement on or in the electrical device (11), wherein each sensor (23, 24, 41) is arranged in an electrical path between the measuring line (25) and the control line (13) and is configured to influence the output signal (A) depending on a parameter to be measured.

2. Measuring assembly according to claim 1, wherein the sensor unit (21) comprises at least two sensors (23, 24, 41) and a coupling device (37), wherein the coupling device (37) is arranged in the electrical path between the sensors (23, 24, 41) and the measuring line (25) and is configured to allow a transmission of the output signal (A) to one of the at least two sensors (23, 24, 41) depending on a characteristic of the output signal (A).

3. Measuring assembly according to claim 2, wherein the coupling device (37) exclusively comprises passive components.

4. Measuring assembly according to claim 2 or 3, wherein the sensor unit (21) comprises a first sensor (23) and a second sensor (24), wherein the coupling device (37) comprises a first blockable component and a second blockable component, wherein a first series connection comprising the first blockable component and the first sensor (23) and a second series connection comprising the second blockable component and the second sensor (24) are connected in parallel to one another between the measuring line (25) and the control line (13).

5. Measuring assembly according to claim 4, wherein the first blockable component is a first diode (38) and the second blockable component is a second diode (39), which are connected anti-parallel to one another and wherein the measuring circuit (22) is configured to produce the output signal (A) so that it comprises different polarities.

6. Measuring assembly according to claim 2 or 3, wherein the coupling device (37) comprises a crossover network (40).

7. Measuring assembly according to claim 6, wherein the measuring circuit (22) is configured to produce the output signal (A) so that it comprises different frequencies (f1, f2).

8. Measuring assembly according to claim 2 or 3, wherein the coupling device (37) comprises a filter arrangement (46).

9. Measuring assembly according to claim 8, wherein the measuring line (25) and the control line (13) are part of a bus line (45) to which the at least two sensors (23, 24, 41) are connected via the filter arrangement (46).

10. Measuring assembly according to any of the preceding claims, wherein the measuring circuit (22) comprises a bootstrap voltage supply (29), which is connected with the control line (13).

11. Measuring assembly according to any of the preceding claims, wherein the measuring circuit comprises a measuring output (27) and wherein the measuring circuit (22) is configured to produce a measuring signal (S) based on the measured parameter (M) and to provide it at the measuring output (27).

12. Measuring assembly according to claim 11, wherein the measuring signal (S) is with regard to the potential independent from the inverter output potential of the control line (13).

13. Measuring assembly according to claim 11 or 12, wherein the measuring output (27) is galvanically separated from the control line (13) and/or the measuring line (25).

14. Measuring assembly according to any of the claims 11 to 13, wherein the measuring output (27) is configured as blank transistor output.

15. Measuring assembly according to any of the preceding claims, wherein the at least one sensor (23, 24, 41) comprises a resistor that is configured to change its resistance value depending on the parameter to be measured.

## Revendications

1. Ensemble de mesure (20) pour un dispositif électrique (11) commandé au moyen d'un circuit inverseur (10) présentant :
- une ligne de commande (13) reliée à une sortie d'inverseur (14) du circuit inverseur (10), sur laquelle est appliqué un potentiel de sortie d'inverseur prédéterminé par le circuit inverseur (10),
- un circuit de mesure (22) qui est relié à une unité de capteur (21) au moyen d'une ligne de mesure (25) et en plus à la ligne de commande (13) et qui est configuré pour transmettre un signal de sortie (A) à l'unité de capteur (21) au moyen de la ligne de mesure (25) et qui est en outre configuré pour détecter une grandeur de mesure électrique (M) sur la ligne de mesure (25) et/ou la ligne de commande (13),
- dans lequel l'unité de capteur (21) présente au moins un capteur (23, 24, 41) qui est configuré pour être disposé sur ou dans le dispositif électrique (11), dans lequel chaque capteur (23, 24, 41) est disposé dans un chemin électrique entre la ligne de mesure (25) et la ligne de commande (13) et configuré pour influer sur le signal de sortie (A) en fonction d'un paramètre à mesurer.

2. Ensemble de mesure selon la revendication 1, dans lequel l'unité de capteur (21) présente au moins deux capteurs (23, 24, 41) et un dispositif de couplage (37), dans lequel le dispositif de couplage (37) est disposé dans le chemin électrique entre les capteurs (23, 24, 41) et la ligne de mesure (25) et est configuré pour autoriser une transmission du signal de sortie (A) à l'un des aux moins deux capteurs (23, 24, 41) en fonction d'une propriété du signal de sortie (A).

3. Ensemble de mesure selon la revendication 2, dans lequel le dispositif de couplage (37) présente exclusivement des éléments de construction passifs.

4. Ensemble de mesure selon la revendication 2 ou 3, dans lequel l'unité de capteur (21) présente un premier capteur (23) et un second capteur (24), dans lequel le dispositif de couplage (37) présente un premier élément verrouillable et un second élément verrouillable, dans lequel un premier montage en série présentant le premier élément verrouillable et le premier capteur (23) et un second montage en série présentant le second élément verrouillable et le second capteur (24) parallèlement l'un à l'autre entre la ligne de mesure (25) et la ligne de commande (13) sont connectés.

5. Ensemble de mesure selon la revendication 4, dans lequel le premier élément verrouillable est une première diode (38) et le second élément verrouillable est une seconde diode (39) qui sont commutées de manière antiparallèle l'une à l'autre et le circuit de mesure (22) est configuré pour générer le signal de sortie (A) de manière à présenter des polarités différentes.

6. Ensemble de mesure selon la revendication 2 ou 3, dans lequel le dispositif de couplage (37) présente un aiguillage de fréquence (40).

7. Ensemble de mesure selon la revendication 6, dans lequel le circuit de mesure (22) est configuré pour générer le signal de sortie (A) de manière à ce qu'il présente des fréquences (f1, f2) différentes.

8. Ensemble de mesure selon la revendication 2 ou 3, dans lequel le dispositif de couplage (37) présente un ensemble de filtre (46).

9. Ensemble de mesure selon la revendication 8, dans lequel la ligne de mesure (25) et la ligne de commande (13) appartiennent à une ligne de bus (45), à laquelle les au moins deux capteurs (23, 24, 41) sont raccordés au moyen de l'ensemble de filtre (46).

10. Ensemble de mesure selon l'une quelconque des revendications précédentes, dans lequel le circuit de mesure (22) présente une alimentation en tension Bootstrap (29) qui est reliée à la ligne de commande (13).

11. Ensemble de mesure selon l'une quelconque des revendications précédentes, dans lequel le circuit de mesure présente une sortie de mesure (27), et dans lequel le circuit de mesure (22) est configuré pour générer un signal de mesure (S) sur la base de la grandeur de mesure (M) et le mettre à disposition à la sortie de mesure (27).

12. Ensemble de mesure selon la revendication 11, dans lequel le signal de mesure (S) est indépendant du potentiel de sortie de l'inverseur de la ligne de commande (13).

13. Ensemble de mesure selon la revendication 11 ou 12, dans lequel la sortie de mesure (27) est isolée galvaniquement de la ligne de commande (13) et/ou de la ligne de mesure (25).

14. Ensemble de mesure selon l'une quelconque des revendications 11 à 13, dans lequel la sortie de mesure (27) est réalisée comme une sortie de transistor non commutée.

15. Ensemble de mesure selon l'une quelconque des revendications précédentes, dans lequel l'au moins un capteur (23, 24, 41) présente une résistance qui est configurée pour modifier sa valeur de résistance en fonction du paramètre à mesurer.
